# EUROPÄISCHE PATENTSCHRIFT

(11) **EP 3 288 773 B1**
(45) Veröffentlichungstag und Bekanntmachung des Hinweises auf die Patenterteilung: **17.11.2021**
(21) Anmeldenummer: 16720749.7
(22) Anmeldetag: 20.04.2016
(51) Int. Cl.: B42D 25/41, B42D 25/415, B42D 25/445, B42D 25/45, B42D 25/324, B42D 25/328, B42D 25/373

(54) **VERFAHREN ZUM HERSTELLEN EINES MEHRSCHICHTKÖRPERS**
METHOD FOR PRODUCING A MULTI-LAYER BODY
PROCÉDÉ DE FABRICATION D'UN CORPS MULTICOUCHE

(30) Priorität: 30.04.2015 DE 102015106800
(43) Veröffentlichungstag der Anmeldung: 07.03.2018
(73) Patentinhaber: Leonhard Kurz Stiftung & Co. KG, 90763 Fürth (DE); OVD Kinegram AG, 6300 Zug (CH)
(72) Erfinder: OLSZOWKA, Violetta, 90513 Zirndorf (DE); STAUB, René, 6332 Hagendorn (CH)
(74) Vertreter: Louis Pöhlau Lohrentz
(86) Internationale Anmeldenummer: PCT/EP2016/058746
(87) Internationale Veröffentlichungsnummer: WO 2016/173898

(56) Entgegenhaltungen:
- EP-A2- 1 634 221
- WO-A1-2014/012657
- WO-A1-2014/207165
- WO-A2-2006/084685
- DE-T2- 69 829 889

## Beschreibung

Die Erfindung betrifft ein Verfahren zum Herstellen eines Mehrschichtkörpers in Form eines Sicherheitselements.

Um Mehrschichtkörper mit ansprechenden graphischen Designs zu erzeugen, ist es bekannt, Photolacke zu verwenden, die entsprechend dem gewünschten Design belichtet und entwickelt werden.

Ferner ist es bekannt, im sogenannten Liftoff-Verfahren einen Waschlack in Form des gewünschten Designs aufzubringen und mit einer weiteren Schicht, beispielsweise einer Metallisierung oder einem weiteren Lack zu überschichten bzw. zu überdecken. Durch Lösemittelbehandlung kann der Waschlack danach zusammen mit Teilen der weiteren Schicht wieder entfernt werden, so dass die weitere Schicht nur dort zurückbleibt, wo kein Waschlack aufgebracht wurde. Sowohl Photolacke als auch Waschlacke sind üblicherweise lösemittelbasiert. Dies ist mit mehreren Nachteilen verbunden.

In Mehrschichtkörpern, die weitere Lackschichten umfassen, können diese weiteren Lackschichten beim Aufbringen eines lösemittelbasierten Lacks angelöst werden, was die Qualität eines solchen Mehrschichtkörpers vermindert. Ferner sind lösemittelbasierte Lacke nicht umweltfreundlich und müssen aufwändig und unter hohen Kosten entsorgt werden.

Bei üblichen Waschlacken ergibt sich zudem das Problem, dass diese meist hochpigmentiert und porös sein sollten, um die gewünschte Ablösefunktion sicherzustellen. Insbesondere die vorgenannte Porosität begrenzt jedoch die erreichbare Auflösung und Randschärfe der mit solchen Waschlacken erzeugten Designs.

Die WO 2006/084685 A2 beschreibt ein Verfahren zur Herstellung eines Mehrschichtkörpers mit einer partiell ausgeformten ersten Schicht sowie einen entsprechenden Mehrschichtkörper.

Die DE 698 29 889 T2 betrifft eine Sicherheitsvorrichtung mit mehreren Sicherheitsmerkmalen.

Die WO 2014/207165 A1 beschreibt ein Verfahren zur Herstellung eines Mehrschichtkörpers sowie einen dadurch hergestellten Mehrschichtkörper.

Die EP 1 634 221 B1 betrifft eine Sicherheitsvorrichtung zur Überprüfung eines maschinell prüfbaren Sicherheitsmerkmals.

Die WO 2014/012657 A1 beschreibt ein Verfahren zur Herstellung eines mehrschichtigen Sicherheitselements.

Es ist damit Aufgabe der vorliegenden Erfindung, ein besonders prozesssicheres Verfahren zum Herstellen von Mehrschichtkörpern mit besonders hoher Qualität bereitzustellen. Diese Aufgabe wird durch ein Verfahren mit den Merkmalen des Patentanspruchs 1 gelöst.

Durch die Verwendung eines wasserbasierten Photolacks können so auch Grundkörper mit einer strukturierten Lackschicht versehen werden, die anfällig gegenüber der Lösemittelkomponente in lösemittelbasierten Lacken sind. Insbesondere können so auch lösemittelbasierte Lackschichten mit dem Photolack überschichtet werden, ohne dass deren Qualität oder Auflösung leidet.

Verglichen mit dem Druck von wasserbasierten Lacken lässt sich durch das beschriebene Verfahren eine deutlich verbesserte Auflösung von bis zu 25 µm, gegebenenfalls auch bis zu 10 µm erreichen. Bei der Verwendung entsprechender Belichtungsmasken in Schritt b) können so beispielsweise hochaufgelöste, fein strukturierte Linienmuster oder andere Rasterungen erzeugt werden. Unter Rasterung ist hierbei eine regelmäßige oder unregelmäßige Anordnung von voneinander beabstandeten Rasterelementen zu verstehen. Rasterelemente können dabei beispielsweise Linien oder Punkte oder andere geometrische Formen sein. Die Rasterelemente und/oder ihre Abstände voneinander können jeweils gleich oder auch unterschiedlich sein. Gleichzeitig ist das beschriebene Verfahren deutlich umweltfreundlicher als die Verwendung von lösemittelbasierten Photolacken. Die Entsorgung anfallender flüssiger Abfälle und gegebenenfalls eine Abluftbehandlung ist damit deutlich einfacher und kostengünstiger.

Bei der Belichtung der ersten Lackschicht vernetzen polymere Komponenten des Lacks, so dass sich dessen Molekulargewicht im belichteten ersten Bereich erhöht. Im ersten Bereich verliert der Lack damit seine Wasserlöslichkeit. Die Entfernung des Lacks im nicht belichteten zweiten Bereich kann damit einfach durch Waschen mit einem wässrigen Lösemittel erfolgen.

Auf diese Weise können einfach und prozesssicher Mehrschichtkörper, insbesondere in Form eines Sicherheitselements mit ansprechenden graphischen Designs erhalten werden, die beispielsweise Verwendung in Sicherheitsdokumenten, wie Banknoten, Wertpapieren, Ausweisdokumenten, Visumsdokumenten, Reisepässen oder Kreditkarten finden können. Auch die Verwendung für besonders fälschungssichere Produktetiketten, Mautvignetten oder dergleichen ist möglich.

Bei einem solchen Sicherheitselement kann es sich beispielsweise um eine Transferfolie, eine Laminierfolie, einen Sicherheitsstreifen, ein Sicherheitsfenster oder dergleichen handeln.

Bevorzugt umfasst der Grundkörper zumindest eine zweite Lackschicht aus einem lösemittelbasierten Lack. Wie oben erläutert, wird eine solche Lackschicht nicht durch den wasserbasierten Photolack oder durch die zu dessen Entwicklung verwendeten Substanzen angegriffen. Auf diese Weise können also ansprechende mehrfarbige Designs geschaffen werden.

Die zweite Lackschicht kann dabei vollflächig vorliegen und somit einen Hintergrund für die erste Lackschicht bilden, oder auch partiell aufgebracht werden und selbst ein Motiv oder Design ausbilden.

Bevorzugt weist die zweite Lackschicht eine Schichtdicke von 0,1 µm bis 10 µm, besonders bevorzugt von 0,1 µm bis 3 µm auf.

Es ist dabei bevorzugt, wenn die erste Lackschicht auf eine Oberfläche der zweiten Lackschicht aufgebracht wird.

Ferner ist es zweckmäßig, wenn zumindest eine weitere Schicht auf die erste Lackschicht aufgebracht wird.

Hierdurch können zusätzliche Designelemente in den Mehrschichtkörper eingebracht werden. Auch funktionale Schichten, wie beispielsweise Schutzlackschichten, können so integriert werden.

Es ist ferner bevorzugt, wenn nach dem Aufbringen der zumindest einen weiteren Schicht die erste Lackschicht und die zumindest eine weitere Schicht im ersten Bereich entfernt wird.

Mit anderen Worten verbleibt die zumindest eine weitere Schicht nur dort, wo die erste Lackschicht nicht vorlag. Die zumindest eine weitere Schicht wird also im Negativ zur ersten Lackschicht strukturiert und bildet somit ein Motiv aus, welches komplementär zum ursprünglich von der ersten Lackschicht gebildeten Motiv ist.

In dieser Ausführungsform wirkt der wasserbasierte Photolack der ersten Schicht also als Waschlack. Verglichen mit üblichen Liftoff-Verfahren, bei denen ein Waschlack aufgedruckt wird, kann aufgrund der Strukturierung der ersten Lackschicht durch Belichtung und Entwicklung eine deutlich höhere Auflösung und Kantenschärfe erreicht werden.

Auch sind wässrige Photolacke verglichen mit üblichen Waschlacken nach dem Aushärten nicht nennenswert porös, was ebenfalls zu einer Verbesserung der Randschärfe im so erzeugten Motiv führt.

Da für die Entfernung der ersten Lackschicht keine organischen Lösemittel notwendig sind, kann ein solches Verfahren auch bei Mehrschichtkörpern angewendet werden, die Schichten enthalten, die in organischen Lösemitteln nicht stabil sind.

Dabei ist es insbesondere bevorzugt, wenn die erste Lackschicht und die zumindest eine weitere Schicht durch Behandlung mit einer sauren Natriummetaperiodatlösung, insbesondere einer wässrigen Lösung von 1,5 Gew.-% Natriummetaperiodat und 0,05 Gew.-% Schwefelsäure, entfernt wird.

Die Entfernung der ersten Lackschicht ist somit ein oxidativer Prozess. Die Beigabe von Säure dient der Stabilisierung des Metaperiodats. Anstelle von Schwefelsäure ist beispielsweise auch Salpetersäure verwendbar. Vorzugsweise beträgt der pH-Wert der Natriummetaperiodatlösung von 1 bis 7, besonders bevorzugt von 2 bis 5.

Vorzugsweise erfolgt die Behandlung mit der sauren Natriummetaperiodatlösung bei einer Temperatur von 15°C bis 70°C, bevorzugt von 25°C bis 50°C, und/oder einer Behandlungsdauer von 600s bis 1s, bevorzugt von 120s bis 10s.

Die Ablösung der ersten Lackschicht kann ferner durch Agitation der Lösung, gezieltes Anströmen des Mehrschichtkörpers, Bürsten, Wischen oder Ultraschallbehandlung unterstützt werden.

Ferner ist es zweckmäßig, wenn der sauren Natriummetaperiodatlösung ein nichtionisches Tensid zugesetzt wird, insbesondere ausgewählt aus der Gruppe Ethoxylat, Alkoxylate primärer oder sekundärer Fettalkohole, Alkylphenole, Ethylenoxid/Propylenoxid-Copolymerisate, Aminethoxylate, Alkylpolyglycolide, Fettaminoxide, Fettsäurealkanolamide, Fettsäurealkylglucamide.

Solche Tenside dienen als Benetzungsmittel und stellen sicher, dass die Natriummetaperiodatlösung die erste Lackschicht und die zumindest eine weitere Lackschicht vollständig benetzt, so dass das gewünschte Ablöseergebnis erzielt werden kann.

Die Konzentration des Tensids beträgt dabei bevorzugt von 0% bis 50%, besonders bevorzugt von 0,01% bis 3%.

Es ist weiter bevorzugt, wenn die zumindest eine weitere Schicht eine dritte Lackschicht, insbesondere aus einem lösemittelbasierten Lack, ist oder umfasst.

Wie bereits erläutert, werden solche Lacke beim Entfernen der ersten Lackschicht nicht angegriffen, so dass die dritte Lackschicht im zweiten Bereich verbleibt.

Bevorzugt handelt es sich um einen Lack aus der Gruppe Acrylate, Polyester, Polyurethane, Copolymere, mit einer Schichtdicke von 0,1 µm bis 10 µm, bevorzugt von 0,1 µm bis 3 µm.

Ferner kann die zumindest eine weitere Schicht eine Reflexionsschicht sein oder umfassen.

Dabei kann es sich um eine Metallschicht, insbesondere aus Aluminium, Kupfer, Silber, Gold, Chrom oder einer Legierung der vorgenannten Metalle handeln.

Alternativ kann die Reflexionsschicht auch als Schicht aus einem hochbrechenden Material (high refractive index, HRI), insbesondere aus Zinksulfid oder Titandioxid, ausgebildet sein.

Die Reflexionsschicht kann jedoch auch aus einer Abfolge von Schichten bestehen, insbesondere aus einer dünnen Metallschicht, einer transparenten Abstandsschicht und einer opaken metallischen Reflexionsschicht oder einer HRI-Schicht, einer transparenten Abstandsschicht mit aus einem Material mit niedrigem Brechungsindex und einer weiteren HRI-Schicht. Einzelne oder mehrere der Metallschicht, Abstandsschicht, Reflexionsschicht können vollflächig oder auch nur partiell vorgesehen sein.

Die Reflexionsschicht kann auch eine Abfolge einer Metallschicht, die insbesondere nur partiell vorgesehen ist, und einer HRI-Schicht aufweisen. Die HRI-Schicht kann dabei vollflächig oder ebenfalls partiell vorgesehen sein.

Die Schichtdicke einer metallischen Reflexionsschicht beträgt bevorzugt von 5 nm bis 150 nm, besonders bevorzugt von 10 nm bis 50 nm. Die Schichtdicke von HRI-Schichten beträgt bevorzugt 30 nm bis 250 nm. Im Dickenbereich von 30 nm bis 75 nm ergibt sich eine eher farbneutrale Reflexion, während bei dickeren Schichten das von der Reflexionsschicht reflektierte Licht ausgeprägte Farben zeigt.

Ferner ist es bevorzugt, wenn die erste Lackschicht auf eine Reflexionsschicht des Grundkörpers aufgebracht wird und vor dem Aufbringen der zumindest einen weiteren Schicht die Reflexionsschicht des Grundkörpers im zweiten Bereich insbesondere durch Ätzen entfernt wird.

Dies ist insbesondere vorteilhaft, wenn die zumindest eine weitere Schicht eine Reflexionsschicht ist oder umfasst. Damit können zwei Reflexionsschichten, bevorzugt aus unterschiedlichen Materialien und damit mit unterschiedlichem optischen Erscheinungsbild passergenau und komplementär zueinander aufgebracht werden.

Es ist weiter bevorzugt, wenn die erste Lackschicht lediglich auf einen Teilbereich der Oberfläche des Grundkörpers aufgebracht wird.

Auf diese Weise können teilflächige Motive erzeugt werden, die andere graphische oder Designelemente des Grundkörpers ergänzen.

Dabei ist es auch möglich, wenn auf einen Teilbereich der ersten Lackschicht und/oder der zumindest einen weiteren Schicht ein Ätzresist aufgebracht wird und die erste Lackschicht und/oder die zumindest eine weitere Schicht dort entfernt wird, wo sie nicht von dem Ätzresist bedeckt ist.

Auch so können teilflächige Motive erzeugt werden. Bei dem Ätzresist handelt es sich bevorzugt um Acrylat-, Polyester-, Epoxy-, Polyurethan-Harze oder Acrylatcopolymere mit einer Schichtdicke von 0,1 µm bis 10 µm, bevorzugt von 0,1 µm bis 5 µm.

Zum Entfernen der ersten Lackschicht und/oder der zumindest einen weiteren Schicht kann wie beschrieben eine saure Natriummetaperiodatlösung unter den oben genannten Bedingungen verwendet werden.

Es ist ferner vorteilhaft, wenn die Belichtung von der Seite des Grundkörpers her erfolgt.

Dabei können Strukturen des Grundkörpers, die für die Belichtungswellenlänge nicht oder nur teiltransparent sind, als interne Belichtungsmaske dienen. Eine externe Maske ist damit nicht nötig, so dass die mit der Verwendung einer externen Maske verbundenen Probleme bezüglich der Anordnung der Maske und der resultierenden Registergenauigkeit nicht auftreten.

Unter Registergenauigkeit ist eine Lagegenauigkeit zweier oder mehr Elemente und/oder Schichten zueinander zu verstehen. Dabei soll sich die

Registergenauigkeit innerhalb einer vorgegebenen Toleranz bewegen und dabei möglichst gering sein. Gleichzeitig ist die Registergenauigkeit von mehreren Elementen und/oder Schichten zueinander ein wichtiges Merkmal, um die Fälschungssicherheit zu erhöhen. Die lagegenaue Positionierung kann dabei insbesondere mittels optisch detektierbarer Passermarken oder Registermarken erfolgen. Diese Passermarken oder Registermarken können dabei entweder spezielle separate Elemente oder Bereiche oder Schichten darstellen oder selbst Teil der zu positionierenden Elemente oder Bereiche oder Schichten sein. Von einem "perfekten Register" spricht man, wenn die Registertoleranz nahe Null bzw. praktisch Null ist.

Insbesondere ist es zweckmäßig, wenn der Grundkörper zumindest eine partielle Schicht, insbesondere eine vierte Lackschicht und/oder eine Reflexionsschicht, umfasst, die im ersten Bereich für einen zur Belichtung der ersten Lackschicht verwendeten Wellenlängenbereich transparent und im zweiten Bereich für einen zur Belichtung der ersten Lackschicht verwendeten Wellenlängenbereich intransparent ist.

Bei der Belichtung der ersten Lackschicht wird diese somit genau im Register mit dieser partiellen Schicht belichtet. Die nicht belichteten Bereiche sind deckungsgleich mit den intransparenten Bereichen der partiellen Schicht und die belichteten Bereiche deckungsgleich mit den transparenten Bereichen der partiellen Schicht. Unter "deckungsgleich" wird dabei eine exakte Überdeckung bei Betrachtung in Richtung der Flächennormalen auf die jeweiligen Schichten verstanden.

Unter einem transparenten Bereich soll ein Bereich verstanden werden, der eine Transmissivität von mindestens 50%, bevorzugt mindestens 70% im jeweiligen Wellenlängenbereich aufweist.

Unter einem intransparenten Bereich soll ein Bereich verstanden werden, der eine Transmissivität von höchstens 30%, bevorzugt höchstens 20% im jeweiligen Wellenlängenbereich aufweist.

Es ist dabei bevorzugt, wenn der Unterschied bzw. der Kontrast zwischen der Transmissivität des transparenten Bereichs und des intransparenten Bereichs mindestens 2, insbesondere mindestens 5 ist.

Die Belichtung erfolgt vorzugsweise bei einer Wellenlänge von 350 nm bis 400 nm mit einer Belichtungszeit von 0,1s bis 120s, bevorzugt von 0,1s bis 60s, und/oder einer Belichtungsdosis von 1 mJ/cm² bis 300 mJ/cm², bevorzugt von 1mJ/cm² bis 100mJ/cm². Verglichen zu bei der Belichtung von lösemittelbasierten Photolacken kann somit besonders schonend mit niedriger Intensität belichtet werden.

Weiter bevorzugt wird zum Entfernen der ersten Lackschicht im zweiten Bereich Wasser mit einem Zusatz von Isopropanol, insbesondere mit 0,1% bis 50% Isopropanol, bevorzugt mit 5% Isopropanol, verwendet.

Wie bereits eingangs erläutert, ist damit eine schonende Entfernung der unbelichteten Photolackschicht möglich, bei der weitere Schichten des Grundkörpers nicht angegriffen werden.

Erfindungsgemäß wird zum Aufbringen der ersten Lackschicht ein wässriger Photolack verwendet, welcher zumindest ein wasserlösliches Polymer, zumindest ein filmbildendes Polymer, zumindest ein Additiv und zumindest einen Photoinitiator enthält.

Dabei ist das wasserlösliche Polymer bevorzugt ausgewählt aus der Gruppe: Arginsäurederivate, Cellulosederivate und/oder carboxylierte Acrylpolymere wie z.B. Natriumcarboxymethylcellulose Methylcellulose, Polyvinylalkoholharze, Polyethylenoxid, homo-und/oder copolymere Vinylacetate, Polyacrylamide, langkettige Carbonsäuren.

Das wasserlösliche Polymer stellt die Ablösbarkeit des nicht belichteten Photolacks durch wässrige Lösemittel sicher und verbessert dessen Dispergierbarkeit.

Vorzugsweise ist das wasserlösliche Polymer in einer Konzentration von 1 Gew.-% bis 50 Gew.-%, bevorzugt von 1 Gew.-% bis 20 Gew.-%, in dem wässrigen Photolack enthalten.

Es ist weiter bevorzugt, wenn das filmbildende Polymer ausgewählt ist aus der Gruppe: Polyvinylacetatharze, Ethylen-Vinylacetat-Copolymere, Vinylacetat-Acrylat-Copolymere, Acrylcopolymere, Polyurethancopolymere, Polyacrylate, Polyurethane, Polyester- und/oder Epoxidharze, Polyvinylpyrrolidon, Urethanacrylat.

Das filmbildende Polymere ist im Lack dispergiert und bildet nach Belichtung und Trocknung die eigentliche Matrix des Lacks aus.

Es ist dabei bevorzugt, wenn das filmbildende Polymer in einer Konzentration von 1Gew.-% bis 50Gew.-%, bevorzugt von 10 Gew.-% bis 30 Gew.-%, im dem wässrigen Photolack enthalten ist.

Um die Dispergierbarkeit und Stabilität des Lacks zu verbessern, ist es zweckmäßig, wenn das zumindest eine Additiv ein Dispergieradditiv ist oder umfasst, welches in einer Konzentration von 0,1 Gew.-% bis 5 Gew.-%, bevorzugt von 0,1 Gew.-% bis 3 Gew.-%, im dem wässrigen Photolack enthalten ist.

Ferner ist es vorteilhaft, wenn das zumindest eine Additiv ein Entschäumer ist oder umfasst, welcher in einer Konzentration von 0,1 Gew.-% bis 5% Gew.-%, bevorzugt von 0,1 Gew.-% bis 3 Gew.-%, im dem wässrigen Photolack enthalten ist. Hierdurch wird die Verarbeitbarkeit des Lacks verbessert.

Es ist weiter bevorzugt, wenn der Photoinitiator ein photosensitives Diazoharz, insbesondere ein 4-Diazodiphenylamin/Formaldehydkondensat, ist oder umfasst, welches in einer Konzentration von 0,1 Gew.-% bis 5Gew.-%, bevorzugt von 0,1 Gew.-% bis 3 Gew.-%, im dem wässrigen Photolack enthalten ist.

Derartige Diazoharze wirken bei UV-Einstrahlung als Quervernetzer, die die Polymerketten des Lacks in den belichteten Bereichen untereinander verknüpfen. Aus der damit verbundenen Erhöhung des Molekulargewichts resultiert eine Abnahme der Wasserlöslichkeit, so dass der belichtete Lack beim Entwickeln nicht abgewaschen wird.

Ferner ist es bevorzugt, wenn der wässrige Photolack 1% bis 30%, bevorzugt 5% bis 15%, Isopropanol enthält.

Es ist besonders bevorzugt, wenn die erste und/oder zweite und/oder dritte und/oder vierte Lackschicht Farbmittel, insbesondere bunte oder unbunte Pigmente und/oder Effektpigmente, UV-anregbare Fluoreszenzpigmente, Dünnschichtfilmsysteme, cholesterische Flüssigkristalle, Farbstoffe und/oder metallische oder nichtmetallische Nanopartikel umfasst. Hierdurch kann eine Vielzahl ansprechender optischer Effekte verwirklicht werden.

Insbesondere ist es dabei zweckmäßig, wenn die erste und/oder zweite und/oder dritte und/oder vierte Lackschicht jeweils unterschiedliche Farbmittel umfassen.

Wenn die jeweiligen Lackschichten auf die oben beschriebene Weise im Register zueinander strukturiert werden, erhält man so ansprechende mehrfarbige Designs, die eine höhere Auflösung und Registergenauigkeit aufweisen als vergleichbare gedruckte Strukturen.

Dabei ist es vorteilhaft, wenn die erste und/oder zweite und/oder dritte und/oder vierte Lackschicht in Form eines graphischen Motivs, alphanumerischen Zeichens, Logos, Bildes, Musters, insbesondere Guillochenmusters, aufgebracht und/oder strukturiert wird.

Auch Kombinationen der genannten Designelemente sind dabei möglich.

Es ist ferner bevorzugt, wenn die erste Lackschicht auf einen Grundkörper aufgebracht wird, der eine oder mehrere der folgenden Schichten umfasst: eine Trägerlage, eine Wachsschicht, eine Ablöseschicht, eine Schutzschicht, eine Replizierschicht mit einem Oberflächenrelief, eine Reflexionsschicht, eine Volumenhologrammschicht, eine Farblackschicht, eine Grundierungsschicht.

Hierdurch können weitere Design-, Sicherheits- und Funktionselemente in den Mehrschichtkörper integriert werden, so dass ein optisch besonders ansprechender, gut verarbeitbarer und besonders fälschungssicherer Mehrschichtkörper erhalten wird.

Die Trägerlage bildet eine stabile Grundlage, auf die der weitere Schichtverbund aufgebaut werden kann und besteht bevorzugt aus Polyester, Polyolefin, Polyvinyl, Polyimid, ABS. Besonders bevorzugt aus PET, PC, PP, PE, PVC, PS mit einer Schichtdicke von 4 µm bis 75 µm, bevorzugt von 6 µm bis 50 µm, weiter bevorzugt von 9 µm bis 26 µm.

Eine Ablöseschicht ist vorzugsweise zwischen der Trägerlage und weiteren Schichten des Grundkörpers angeordnet und besteht bevorzugt aus Wachs oder Silikon mit einer Schichtdicke von 0,005 µm bis 0,3 µm, bevorzugt von 0,01 µm bis 0,1 µm. Die Ablöseschicht kann alternativ auch aus einem stark verfilmenden Acrylatpolymer/-copolymer bestehen und/oder auch Teil der Schutzlackschicht sein und dabei eine Schichtdicke von 1 µm bis 5 µm, bevorzugt 1 µm bis 3 µm aufweisen. Die Ablöseschicht ermöglicht es, bei der Übertragung des Mehrschichtkörpers auf ein Sicherheitsdokument die Trägerlage problemlos abzulösen.

Eine Grundierungsschicht bildet bevorzugt die Oberfläche des Grundkörpers, auf die die erste Lackschicht aufgebracht wird und dient der Haftvermittlung für die erste Lackschicht. Bevorzugt besteht die Grundierungsschicht aus Polyester, Epoxid, Polyurethan, Acrylat und/oder Copolymerharzen oder Mischungen daraus, mit einer Schichtdicke von 0,5 µm bis 15 µm, bevorzugt von 1 µm bis 5 µm, weiter bevorzugt von 1 µm bis 3 µm. Alternativ können auch thermoplastische Kleber, Heißwachse, UV-härtbare Kleber oder Kaltkleber bzw. selbstklebende Kleber verwendet werden.

Replizierschichten dienen der Erzeugung optisch variabler Effekte, beispielsweise von Oberflächenhologrammen. Bevorzugt besteht die Replizierschicht aus Acrylaten oder Acrylatcopolymeren wie Urethanacrylaten, Polyesteracrylaten, Epoxyacrylaten oder Acrylatcopolymeren, Polyesteracrylaten, mit einer Schichtdicke von 0,1 µm bis 50µm, bevorzugt von 0,2 µm bis 5 µm. Die Replizierschichten können thermoplastisch strukturierbar und/oder auch strahlenhärtbar sein, insbesondere mittels UV-Strahlung.

Reflexionsschichten dienen der Verbesserung der Sichtbarkeit von solchen optisch variablen Effekten und können auch zur Verwirklichung weiterer Designeffekte verwendet werden.

Dabei kann es sich um eine Metallschicht, insbesondere aus Aluminium, Kupfer, Silber, Gold, Chrom oder einer Legierung der vorgenannten Metalle handeln. Alternativ kann die Reflexionsschicht auch als Schicht aus einem hochbrechenden Material (high refractive index, HRI), insbesondere aus Zinksulfid oder Titandioxid, ausgebildet sein.

Die Schichtdicke einer metallischen Reflexionsschicht beträgt bevorzugt von 5 nm bis 150 nm, besonders bevorzugt von 10 nm bis 50 nm. Die Schichtdicke von HRI-Schichten beträgt bevorzugt von 30 nm bis 250 nm. Im Dickenbereich von 30 nm bis 75 nm ergibt sich eine eher farbneutrale Reflexion, während bei dickeren Schichten das von der Reflexionsschicht reflektierte Licht ausgeprägte Farben zeigt.

Schutzschichten können verwendet werden, um eine gegen Umwelteinflüsse stabile äußere Oberfläche des Mehrschichtkörpers zu bilden. Bevorzugte Lacke hierfür sind Polyacrylate, Acrylatverbindungen und/oder Polymethacrylate, Epoxide, Polyvinylidenfluoride mit einer Schichtdicke von 1 µm bis 10 µm, bevorzugt von 1 µm bis 5 µm.

Volumenhologrammschichten dienen ebenfalls der Erzeugung optisch variabler Effekte und bestehen typischerweise aus einem Monomer, einem Initiator und einem photosensitiven Farbstoff. Sie enthalten bevorzugt Substanzen aus den folgenden Gruppen Acrylate, Amide, Epoxide, Vinylester, Vinylether, Styrole, Polyole, Polyisocyanate, Acrylamide, Polyvinylalcohol, Polyurethane, mit einer Schichtdicke von 3 µm bis 50 µm , bevorzugt von 5 µm bis 25 µm.

Es ist ferner bevorzugt, wenn das in die Replizierschicht eingebrachte OberFlächenrelief ein optisch variables Element, insbesondere ein Hologramm, Kinegram® oder Trustseal®, ein vorzugsweise lineares oder gekreuztes sinusförmiges Beugungsgitter, ein lineares oder gekreuztes ein- oder mehrstufiges Rechteckgitter, eine Beugungsstruktur Nullter Ordnung, eine asymmetrische Reliefstruktur, ein Blaze-Gitter, eine vorzugsweise isotrope oder anisotrope, Mattstruktur, oder eine lichtbeugende und/oder lichtbrechende und/oder lichtfokussierende Mikro- oder Nanostruktur, eine binäre oder kontinuierliche Fresnelllinsen, eine binäre oder kontinuierliche Fresnel-Freiformfläche, eine Mikroprismenstruktur oder eine Kombinationsstruktur daraus ausbildet.

Hierdurch kann eine Vielzahl ansprechender und fälschungssicherer optisch variabler Effekte erzeugt werden.

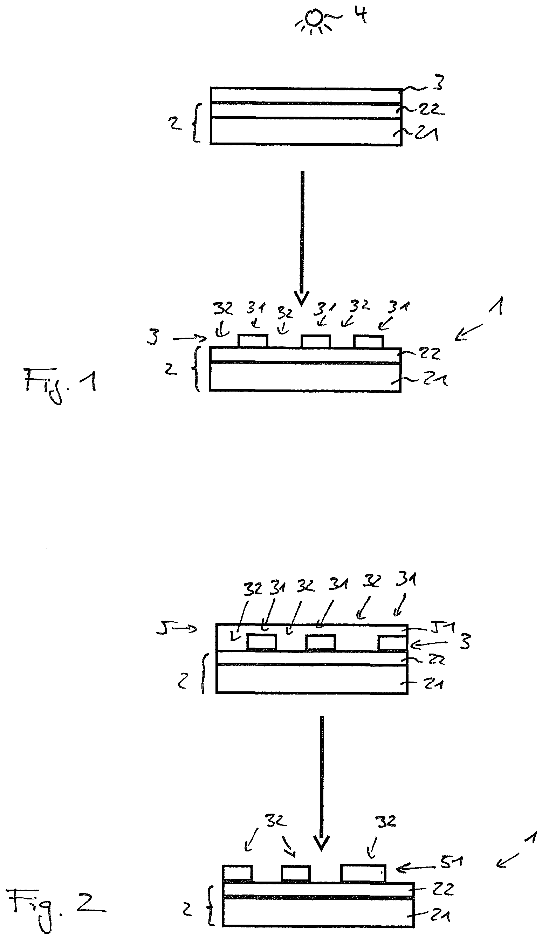

Die Erfindung wird nun anhand von Ausführungsbeispielen näher erläutert. Es zeigen
- Fig. 1: Eine schematische Darstellung der Verfahrensschritte bei der Herstellung eines Ausführungsbeispiels eines Mehrschichtkörpers mit einer strukturierten Schicht aus einem wasserbasierten Photolack;
- Fig. 2: Eine schematische Darstellung der Verfahrensschritte bei der Herstellung eines alternativen Ausführungsbeispiels eines Mehrschichtkörpers unter Verwendung eines wasserbasierten Photolacks als Waschlack für eine weitere Lackschicht;

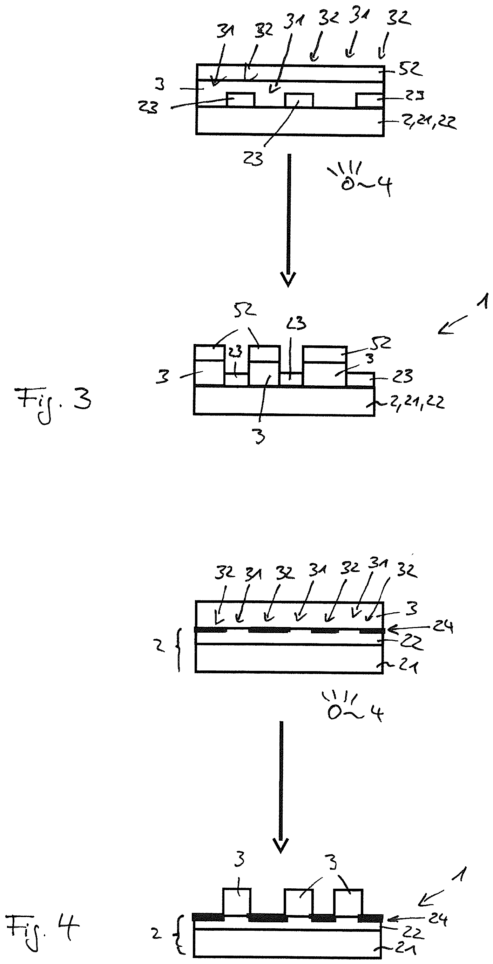

- Fig. 3: Eine schematische Darstellung der Verfahrensschritte bei der Herstellung eines weiteren alternativen Ausführungsbeispiels eines Mehrschichtkörpers mit einer strukturierten Schicht aus einem wasserbasierten Photolack unter Verwendung einer partiellen Lackschicht als interne Belichtungsmaske;
- Fig. 4: Eine schematische Darstellung der Verfahrensschritte bei der Herstellung eines weiteren alternativen Ausführungsbeispiels eines Mehrschichtkörpers mit einer strukturierten Schicht aus einem wasserbasierten Photolack unter Verwendung einer partiellen Metallschicht als interne Belichtungsmaske;

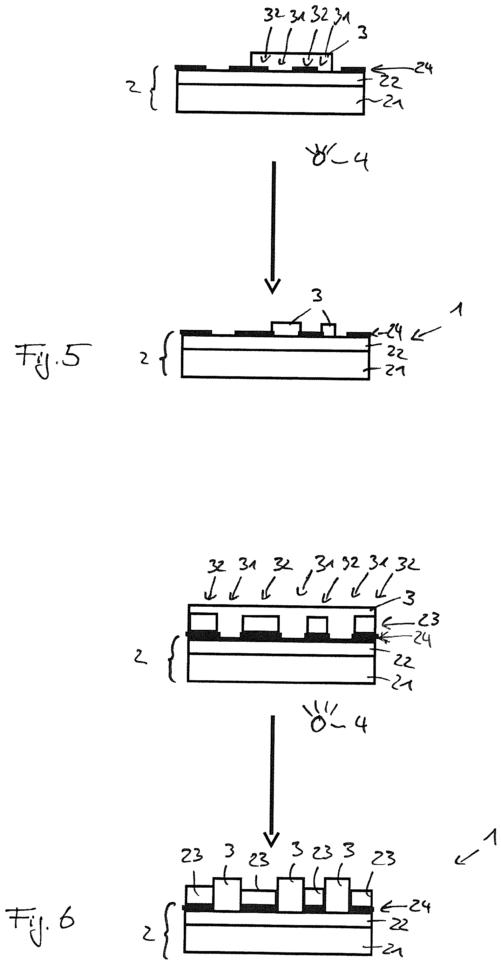

- Fig. 5: Eine schematische Darstellung der Verfahrensschritte bei der Herstellung eines weiteren alternativen Ausführungsbeispiels eines Mehrschichtkörpers mit einer strukturierten partiellen Schicht aus einem wasserbasierten Photolack unter Verwendung einer partiellen Metallschicht als interne Belichtungsmaske;
- Fig. 6: Eine schematische Darstellung der Verfahrensschritte bei der Herstellung eines weiteren alternativen Ausführungsbeispiels eines Mehrschichtkörpers mit einer strukturierten Schicht aus einem wasserbasierten Photolack unter Verwendung einer partiellen Metallschicht und partiellen Lackschicht als interne Belichtungsmaske;

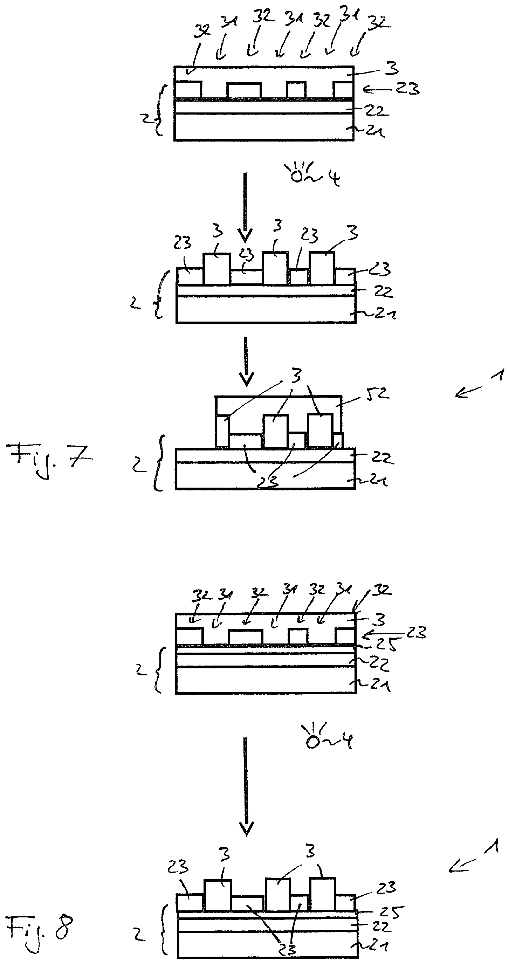

- Fig. 7: Eine schematische Darstellung der Verfahrensschritte bei der Herstellung eines weiteren alternativen Ausführungsbeispiels eines Mehrschichtkörpers mit einer strukturierten Schicht aus einem wasserbasierten Photolack unter Verwendung einer partiellen Lackschicht als interne Belichtungsmaske und anschließender Strukturierung durch einen Ätzresist;
- Fig. 8: Eine schematische Darstellung der Verfahrensschritte bei der Herstellung eines weiteren alternativen Ausführungsbeispiels eines Mehrschichtkörpers mit einer strukturierten Schicht aus einem wasserbasierten Photolack unter Verwendung einer partiellen Lackschicht als interne Belichtungsmaske;

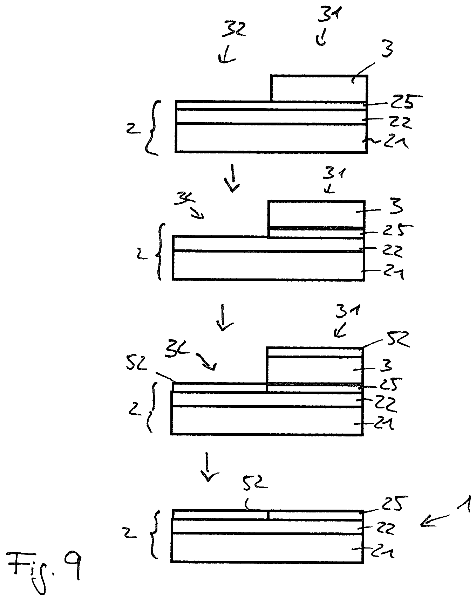

- Fig. 9: Eine schematische Darstellung der Verfahrensschritte bei der Herstellung eines alternativen Ausführungsbeispiels eines Mehrschichtkörpers unter Verwendung eines wasserbasierten Photolacks als Waschlack zur Erzeugung von zwei komplementären Reflexionsschichten;

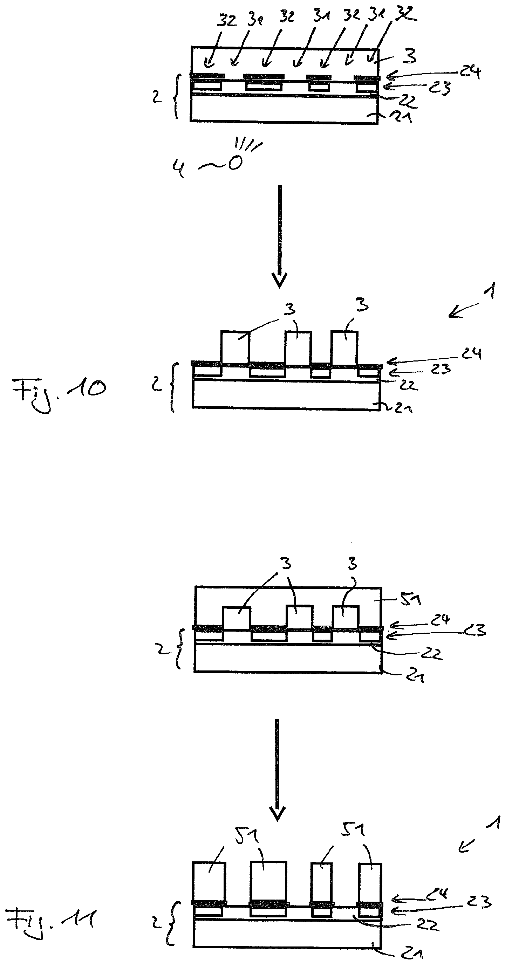

- Fig. 10: Eine schematische Darstellung der Verfahrensschritte bei der Herstellung eines weiteren alternativen Ausführungsbeispiels eines Mehrschichtkörpers mit einer strukturierten Schicht aus einem wasserbasierten Photolack unter Verwendung einer partiellen Metallschicht und partiellen Lackschicht als interne Belichtungsmaske;
- Fig. 11: Eine schematische Darstellung der Verfahrensschritte bei der Weiterverarbeitung des Mehrschichtkörpers gemäß Fig. 10 unter Verwendung des wasserbasierten Photolacks als Waschlack zur Strukturierung einer weiteren Farblackschicht.

Bei der Herstellung eines Mehrschichtkörpers 1 wird zunächst ein Grundkörper 2 bereitgestellt, welcher eine Trägerlage 21 und einen Schichtverbund 22 aufweist. Auf die der Trägerlage 21 abgewandte Seite des Grundkörpers 2 wird eine erste Lackschicht 3 aus einem wasserbasierten Photolack aufgetragen und mittels einer in der Figur 1 nicht dargestellten Maske belichtet.

Das Licht einer UV-Lichtquelle 4 fällt dabei nur auf Teilbereiche 31 der ersten Lackschicht 3 ein, die von der Maske nicht beschattet werden. Die von der Maske beschatteten Teilbereiche 32 werden dagegen nicht belichtet. Bei der anschließenden Entwicklung der ersten Lackschicht 3 verbleibt der belichtete Lack in den Teilbereichen 31, während der Lack in den Teilbereichen 32 durch das Entwicklungsmittel entfernt wird.

Der nachfolgend geschilderte Aufbau des Grundkörpers 2 gilt für alle im Folgenden beschriebenen Ausführungsformen.

Die Trägerlage 21 bildet eine stabile Grundlage, auf die der weitere Schichtverbund 22 aufgebaut werden kann und besteht bevorzugt aus Polyester, Polyolefin, Polyvinyl, Polyimid, ABS. Besonders bevorzugt aus PET, PC, PP, PE, PVC, PS mit einer Schichtdicke von 4 µm bis 75 µm, bevorzugt von 6 µm bis 50 µm, weiter bevorzugt von 9 µm bis 25 µm.

Der Schichtverbund 22 kann eine oder mehrere der folgenden Schichten umfassen: eine Trägerlage, , eine Wachsschicht, eine Ablöseschicht, eine Schutzschicht, eine Replizierschicht mit einem Oberflächenrelief, eine Reflexionsschicht, eine Volumenhologrammschicht, eine Farblackschicht, eine Grundierungsschicht.

Eine Ablöseschicht ist vorzugsweise zwischen der Trägerlage 21 und weiteren Schichten des Grundkörpers 2 angeordnet und besteht bevorzugt aus Wachs oder Silikon mit einer Schichtdicke von 0,0005 µm bis 0,3µm, bevorzugt von 0,01 µm bis 0,1 µm. Die Ablöseschicht kann alternativ auch aus einem stark verfilmenden Acrylatpolymer/-copolymer bestehen und/oder auch Teil der Schutzlackschicht sein und dabei eine Schichtdicke von 1 µm bis 5 µm, bevorzugt 1 µm bis 3 µm aufweisen. Die Ablöseschicht ermöglicht es, bei der Übertragung des Mehrschichtkörpers 1 auf ein Sicherheitsdokument die Trägerlage 21 problemlos abzulösen.

Eine Grundierungsschicht bildet bevorzugt die Oberfläche des Grundkörpers 2, auf die die erste Lackschicht 3 aufgebracht wird und dient der Haftvermittlung für die erste Lackschicht 3. Bevorzugt besteht die Grundierungsschicht aus Polyester, Epoxid, Polyurethan, Acrylat und/oder Copolymerharzen oder deren Mischungen, mit einer Schichtdicke von 1 µm bis 5 µm, bevorzugt von 1 µm bis 3 µm. Alternativ können auch thermoplastische Kleber, Heißwachse, UV-härtbare Kleber oder Kaltkleber bzw. selbstklebende Kleber verwendet werden. Replizierschichten dienen der Erzeugung optisch variabler Effekte, beispielsweise von Oberflächenhologrammen. Bevorzugt besteht die Replizierschicht aus Acrylaten oder Acrylatcopolymeren wie Urethanacrylaten, Polyesteracrylaten, Epoxyacrylaten oder Acrylatcopolymeren, Polyesteracrylaten, mit einer Schichtdicke von 0,1 µm bis 50 µm, bevorzugt von 0,2 µm bis 5 µm.

In die Replizierschicht kann ein Oberflächenrelief eingebracht werden, welches ein optisch variables Element ausbildet, insbesondere ein Hologramm, Kinegram® oder Trustseal®, ein vorzugsweise lineares oder gekreuztes sinusförmiges Beugungsgitter, ein lineares oder gekreuztes ein- oder mehrstufiges Rechteckgitter, eine Beugungsstruktur Nullter Ordnung, eine asymmetrische Reliefstruktur, ein Blaze-Gitter, eine vorzugsweise isotrope oder anisotrope, Mattstruktur, oder eine lichtbeugende und/oder lichtbrechende und/oder lichtfokussierende Mikro- oder Nanostruktur, eine binäre oder kontinuierliche Fresnelllinsen, eine binäre oder kontinuierliche Fresnel-Freiformfläche, eine Mikroprismenstruktur oder eine Kombinationsstruktur daraus.

Reflexionsschichten dienen der Verbesserung der Sichtbarkeit von solchen optisch variablen Effekten und können auch zur Verwirklichung weiterer Designeffekte verwendet werden.

Dabei kann es sich um eine Metallschicht, insbesondere aus Aluminium, Kupfer, Silber, Gold, Chrom oder einer Legierung der vorgenannten Metalle handeln. Alternativ kann die Reflexionsschicht auch als Schicht aus einem hochbrechenden Material (high refractive index, HRI), insbesondere aus Zinksulfid oder Titandioxid, ausgebildet sein.

Die Schichtdicke einer metallischen Reflexionsschicht beträgt bevorzugt von 5 nm bis 150 nm, besonders bevorzugt von 10 nm bis 50 nm. Die Schichtdicke von HRI-Schichten beträgt bevorzugt von 30 nm bis 250 nm. Im Dickenbereich von 30 nm bis 75 nm ergibt sich eine eher farbneutrale Reflexion, während bei dickeren Schichten das von der Reflexionsschicht reflektierte Licht ausgeprägte Farben zeigt.

Schutzschichten können verwendet werden, um eine gegen Umwelteinflüsse stabile äußere Oberfläche des Mehrschichtkörpers zu bilden. Bevorzugte Lacke hierfür sind Polyacrylate, Acrylatverbindungen und/oder Polymethacrylate,, Epoxide, Polyvinylidenfluoride mit einer Schichtdicke von 1 µm bis 10 µm, bevorzugt von 1 µm bis 5 µm.

Volumenhologrammschichten dienen ebenfalls der Erzeugung optisch variabler Effekte und bestehen typischerweise aus einem Monomer, einem Initiator und einem photosensitiven Farbstoff. Sie enthalten bevorzugt Substanzen aus den folgenden Gruppen Acrylate, Amide, Epoxide, Vinylester, Vinylether, Styrole, Polyole, Polyisocyanate, Acrylamide, Polyvinylalcohol, Polyurethane,, mit einer Schichtdicke von 3 µm bis 50 µm, bevorzugt von 5 µm bis 25 µm.

Farblackschichten des Schichtverbunds 22 können lösemittelbasiert sein und weisen eine bevorzugte Schichtdicke von 0,1 µm bis 10 µm, besonders bevorzugt von 0,2 µm bis 5 µm auf. Die Farblackschichten sind mittels Pigmenten und/oder Farbstoffen eingefärbt. Die Pigmente und/oder Farbstoffe können dabei im sichtbaren Licht, aber auch alternativ oder zusätzlich auch im infraroten Licht (IR-Licht) und/oder im ultravioletten Licht (UV-Licht) eine Farbwirkung entfalten. Mittels optisch variabler Pigmente können die Farblackschichten auch optisch variable Effekte aufweisen.

Die erste Lackschicht 3 besteht bevorzugt aus einem wässrigen Photolack, welcher zumindest ein wasserlösliches Polymer, zumindest ein filmbildendes Polymer, zumindest ein Additiv und zumindest einen Photoinitiator enthält.

Eine entsprechende Zusammensetzung des Lacks der ersten Lackschicht 3 gilt alle beschriebenen Ausführungsbeispiele.

Dabei ist das wasserlösliche Polymer bevorzugt ausgewählt aus der Gruppe: Arginsäurederivate, Cellulosederivate und/oder carboxylierte Acrylpolymere wie z.B. Natriumcarboxymethylcellulose Methylcellulose, Polyvinylalkoholharze, Polyethylenoxid, homo-und/oder copolymere Vinylacetate, Polyacrylamide, langkettige Carbonsäuren.

Das wasserlösliche Polymer stellt die Ablösbarkeit des nicht belichteten Photolacks durch wässrige Lösemittel sicher und verbessert dessen Dispergierbarkeit.

Vorzugsweise ist das wasserlösliche Polymer in einer Konzentration von 1 Gew.-% bis 50 Gew.-%, bevorzugt von 1 Gew.-% bis 20 Gew.-%, in dem wässrigen Photolack enthalten.

Es ist weiter bevorzugt, wenn das filmbildende Polymer ausgewählt ist aus der Gruppe: Polyvinylacetatharze, Ethylen-Vinylacetat-Copolymere, Vinylacetat-Acrylat-Copolymere, Acrylcopolymere, Polyurethancopolymere, Polyacrylate, Polyurethane, Polyester- und/oder Epoxidharze, Polyvinylpyrrolidon, Urethanacrylat.

Das filmbildende Polymere ist im Lack dispergiert und bildet nach Belichtung und Trocknung die eigentliche Matrix des Lacks aus.

Es ist dabei bevorzugt, wenn das filmbildende Polymer in einer Konzentration von 1 Gew.-% bis 50 Gew.-%, bevorzugt von 10 Gew.-% bis 30 Gew.-%, im dem wässrigen Photolack enthalten ist.

Um die Dispergierbarkeit und Stabilität des Lacks zu verbessern, ist es zweckmäßig, wenn das zumindest eine Additiv ein Dispergieradditiv ist oder umfasst, welches in einer Konzentration von 0,1 Gew.-% bis 5 Gew.-%, bevorzugt von 0,1 Gew.-% bis 3 Gew.-%, im dem wässrigen Photolack enthalten ist.

Ferner ist es vorteilhaft, wenn das zumindest eine Additiv ein Entschäumer ist oder umfasst, welcher in einer Konzentration von 0,1 Gew.-% bis 5 Gew.-%, bevorzugt von 0,1 Gew.-% bis 3 Gew.-%, im dem wässrigen Photolack enthalten ist. Hierdurch wird die Verarbeitbarkeit des Lacks verbessert.

Es ist weiter bevorzugt, wenn der Photoinitiator ein photosensitives Diazoharz, insbesondere ein 4-Diazodiphenylamin/Formaldehydkondensat, ist oder umfasst, welches in einer Konzentration von 0,1 Gew.-% bis 5 Gew.-%, bevorzugt von 0,1 Gew.-% bis 3 Gew.-%, im dem wässrigen Photolack enthalten ist.

Derartige Diazoharze wirken bei UV-Einstrahlung als Quervernetzer, die die Polymerketten des Lacks in den belichteten Bereichen untereinander verknüpfen. Aus der damit verbundenen Erhöhung des Molekulargewichts resultiert eine Abnahme der Wasserlöslichkeit, so dass der belichtete Lack beim Entwickeln nicht abgewaschen wird.

Ferner ist es bevorzugt, wenn der wässrige Photolack 1% bis 30%, bevorzugt 5% bis 15%, Isopropanol enthält.

Die erste Lackschicht 3 umfasst ferner bevorzugt Farbmittel, insbesondere bunte oder unbunte Pigmente und/oder Effektpigmente, UV-anregbare Fluoreszenzpigmente, Dünnschichtfilmsysteme, cholesterische Flüssigkristalle, Farbstoffe und/oder metallische oder nichtmetallische Nanopartikel. Diese Pigmente und/oder Farbstoffe können dabei im sichtbaren Licht, aber auch alternativ oder zusätzlich auch im infraroten Licht (IR-Licht) und/oder im ultravioletten Licht (UV-Licht) eine Farbwirkung entfalten. Mittels optisch variabler Pigmente können die Farblackschichten auch optisch variable Effekte aufweisen.

Beispiele für Lackformulierungen sind in den folgenden Tabellen angegeben:

| **Lackformulierung 1** | **Gew.-%** |
|---|---|
| Polyvinylalkohol | 1,6 |
| Polyvinylpyrrolidon | 13,4 |
| D iazod iphenylam in/F orm aldehyd-Kondensat - Hydrogensulfat (komplexiert mit Zinkchlorid) | 0,45 |
| Dispergieradditiv, z.B. Disperbyk 190 | 0,25 |
| Entschäumer, z.B. BYK 012 | 0,125 |
| Isopropanol | 9,55 |
| Wasser | 74,625 |

| **Lackformulierung 1 (gefärbt)** | **Gew.-%** |
|---|---|
| Polyvinylalkohol | 1,6 |
| Polyvinylpyrrolidon | 13,4 |
| D iazod iphenylam in/F orm aldehyd-Kondensat - Hydrogensulfat (komplexiert mit Zinkchlorid) | 0,45 |
| Dispergieradditiv, z.B. Disperbyk 190 | 0,25 |
| Entschäumer, z.B. BYK 012 | 0,125 |
| Isopropanol | 9,55 |
| Wasser | 69,025 |
| Farbstoffdispersion oder Farbstoff (z.B. Eisenoxid, Luconyl NG) | 5,6 |

| **Lackformulierung 2** | **Gew.-%** |
|---|---|
| Aliphatisches Urethanacrylatoligomer | 20 |
| Wasserlösliches Diacrylatmonomer | 2 |
| D iazod iphenylam in/F orm aldehyd-Kondensat - Hydrogensulfat (komplexiert mit Zinkchlorid) | 0,62 |
| Dispergieradditiv, z.B. Disperbyk 190 | 0,25 |
| Entschäumer, z.B. BYK 012 | 0,13 |
| Wasser | 77 |

Die Belichtung der ersten Lackschicht 3 erfolgt vorzugsweise bei einer Wellenlänge von 350 nm bis 400 nm mit einer Belichtungszeit von 0,1s bis 120s, bevorzugt von 0,1s bis 60s, und/oder einer Belichtungsdosis von 1mJ/cm² bis 300 mJ/cm², bevorzugt von 1mJ/cm² bis 100mJ/cm².

Als UV-Lichtquelle 4 können dabei insbesondere UV-LEDs verwendet werden. Geeignet sind weiterhin Quecksilberdampflampen, die auch Dotierungen aufweisen können, wie bspw. mit Gallium oder Eisen, um das Strahlungsspektrum auf die Empfindlichkeit des Photoaktivators und das Transmissionsverhalten der Lackschichten anzupassen.

Weiterhin können auch Laser zur Belichtung eingesetzt werden. Aufgrund von deren Strahlqualität können sie auch vermittels einer Ablenkeinheit zur gesteuerten partiellen Belichtung verwendet werden und so beispielsweise eine individuelle Belichtung vornehmen.

Bei der Belichtung wird der Photoaktivator aktiviert und wirkt als Quervernetzer für die Polymerketten des Lacks im Bereich 31, so dass dort dessen Wasserlöslichkeit verloren geht.

Zum Entwickeln, also zum Entfernen der ersten Lackschicht 3 im zweiten Bereich 32, kann dann bevorzugt Wasser mit einem Zusatz von Isopropanol, insbesondere mit 1% bis 30% Isopropanol, bevorzugt mit 5% Isopropanol, verwendet werden, so dass eine schonende Entfernung der nicht belichteten Bereiche 32 ermöglicht wird, ohne dass andere Schichten des Schichtverbunds 22 angegriffen werden.

Um die Anbindung bzw. eine ausreichende Haftung der ersten Lackschicht 3 oder weiterer Schichten sicherzustellen, kann vor dem Aufbringen eine Vorbehandlung durchgeführt werden, bspw. mittels Corona oder Plasma.

Wie Fig. 2 zeigt, kann nach dem Belichten und Entwickeln der ersten Lackschicht 3 ein weiterer Schichtverbund 5 auf diese aufgebracht werden. Im Ausführungsbeispiel nach Fig. 2 ist dies lediglich eine einzelne Lackschicht 51 aus einem Farblack.

Die Lackschicht 51 umfasst ferner bevorzugt Farbmittel, insbesondere bunte oder unbunte Pigmente und/oder Effektpigmente, UV-anregbare Fluoreszenzpigmente, Dünnschichtfilmsysteme, cholesterische Flüssigkristalle, Farbstoffe und/oder metallische oder nichtmetallische Nanopartikel. Diese Pigmente und/oder Farbstoffe können dabei im sichtbaren Licht, aber auch alternativ oder zusätzlich auch im infraroten Licht (IR-Licht) und/oder im ultravioletten Licht (UV-Licht) eine Farbwirkung entfalten. Mittels optisch variabler Pigmente können die Farblackschichten auch optisch variable Effekte aufweisen.

Bevorzugt beträgt die Schichtdicke der Lackschicht 51 von 0,1 µm bis 10 µm, besonders bevorzugt von 1 µm bis 5 µm.

Nach dem Auftragen der Lackschicht 51 wird die erste Lackschicht 3 wieder entfernt. Der wässrige Photolack der ersten Lackschicht 3 dient hier also als Waschlack. Dabei wird in den Bereichen 31 nicht nur die erste Lackschicht 3, sondern auch die Lackschicht 51 mit entfernt, so dass diese nur in den Bereichen 32 verbleibt.

Dabei ist es insbesondere bevorzugt, wenn die erste Lackschicht 31 und die Lackschicht 51 durch Behandlung mit einer sauren Natriummetaperiodatlösung, insbesondere einer wässrigen Lösung von 1,5 Gew.-% Natriummetaperiodat und 0,05 Gew.-% Schwefelsäure, entfernt wird.

Die Entfernung der ersten Lackschicht 31 ist somit ein oxidativer Prozess. Die Beigabe von Säure dient der Stabilisierung des Metaperiodats. Anstelle von Schwefelsäure ist beispielsweise auch Salpetersäure verwendbar.

Vorzugsweise beträgt der pH-Wert der Natriummetaperiodatlösung von 1 bis 7, besonders bevorzugt von 2 bis 5.

Vorzugsweise erfolgt die Behandlung mit der sauren Natriummetaperiodatlösung bei einer Temperatur von 15°C bis 70°C, bevorzugt von 25°C bis 50°C, und/oder einer Behandlungsdauer von 600s bis 1s, bevorzugt von 120s bis 10s..

Die Ablösung der ersten Lackschicht 31 kann ferner durch Agitation der Lösung, gezieltes Anströmen des Mehrschichtkörpers, Bürsten, Wischen oder Ultraschallbehandlung unterstützt werden.

Ferner ist es zweckmäßig, wenn der sauren Natriummetaperiodatlösung ein nichtionisches Tensid zugesetzt wird, insbesondere ausgewählt aus der Gruppe Ethoxylat, Alkoxylate primärer oder sekundärer Fettalkohole, Alkylphenole, Ethylenoxid/Propylenoxid-Copolymerisate, Aminethoxylate, Alkylpolyglycolide, Fettaminoxide, Fettsäurealkanolamide, Fettsäurealkylglucamide.

Solche Tenside dienen als Benetzungsmittel und stellen sicher, dass die Natriummetaperiodatlösung die erste Lackschicht 31 und die Lackschicht 51 vollständig benetzt, so dass das gewünschte Ablöseergebnis erzielt werden kann.

Die Konzentration des Tensids beträgt dabei bevorzugt von 0% bis 50%, besonders bevorzugt von 0,01% bis 3%.

In der Ausführungsform nach Fig. 3 umfasst der Grundkörper 22 eine partielle Lackschicht 23. Diese ist für den zur Belichtung der ersten Lackschicht 3 verwendeten Wellenlängenbereich intransparent, weist also in diesem Wellenlängenbereiche bevorzugt eine Transmissivität von weniger als 20 % auf.

Ferner wird vor dem Belichten und Entwickeln der ersten Lackschicht 3 eine Metallschicht 52 auf die erste Lackschicht 3 aufgebracht. Diese besteht insbesondere aus Aluminium, Kupfer, Silber, Gold, Chrom oder einer Legierung der vorgenannten Metalle mit einer Schichtdicke von 1 nm bis 1 µm, bevorzugt von 10 nm bis 100 nm.

Die Belichtung der ersten Lackschicht 3 erfolgt in diesem Fall von der Seite des Grundkörpers 2 aus. In den Bereichen 31, wo die partielle Lackschicht 23 nicht vorliegt, wird die erste Lackschicht 3 belichtet, in den Bereichen 32, wo die partielle Lackschicht 23 vorliegt, erfolgt keine Belichtung, so dass beim anschließenden Entwickeln der partiellen Lackschicht 3 diese zusammen mit der Metallschicht 52 in den Bereichen 32 entfernt wird. Die partielle Lackschicht 3 und die Metallschicht 52 bilden somit ein zur partiellen Lackschicht 23 komplementäres Motiv aus.

In der Ausführungsform nach Fig. 4 umfasst der Grundkörper 22 eine partielle Metallschicht 24. Analog zur partiellen Lackschicht 23 gemäß Fig. 3 ist diese für den zur Belichtung der ersten Lackschicht 3 verwendeten Wellenlängenbereich intransparent.

Die partielle Metallschicht 24 besteht insbesondere aus Aluminium, Kupfer, Silber, Gold, Chrom oder einer Legierung der vorgenannten Metalle mit einer Schichtdicke von 1 nm bis 1 µm, bevorzugt von 1 0nm bis 100 nm.

Die Belichtung der ersten Lackschicht 3 erfolgt auch hier von der Seite des Grundkörpers 2 aus. In den Bereichen 31, wo die partielle Metallschicht 24 nicht vorliegt, wird die erste Lackschicht 3 belichtet, in den Bereichen 32, wo die partielle Metallschicht 24 vorliegt, erfolgt keine oder nur eine geringe Belichtung, so dass beim anschließenden Entwickeln der partiellen Lackschicht 3 diese in den Bereichen 32 entfernt wird. Die erste Lackschicht 3 bildet somit ein zur partiellen Metallschicht 24 komplementäres Motiv aus.

Das Ausführungsbeispiel nach Fig. 5 entspricht demjenigen nach Fig. 4 und unterscheidet sich nur dadurch, dass die erste Lackschicht 31 nicht vollflächig, sondern lediglich partiell auf den Grundkörper 2 aufgebracht wird.

Auch das Ausführungsbeispiel nach Fig. 6 entspricht demjenigen nach Fig. 4 und unterscheidet sich nur dadurch, dass der Grundkörper zusätzlich zur partiellen Metallschicht 24 eine partielle Lackschicht 23 aufweist, die in Richtung der Flächennormalen auf die Erstreckungsebene des Grundkörpers deckungsgleich zur partiellen Metallschicht 24 ist.

Das Ausführungsbeispiel nach Fig. 7 entspricht dem Ausführungsbeispiel nach Fig. 3. Es wird jedoch auf das Aufbringen der Metallschicht 51 auf die erste Lackschicht 3 verzichtet. Auch hier wird die erste Lackschicht 3 unter Verwendung einer partiellen Lackschicht 23 des Grundkörpers 2 als interne Maske von der Seite des Grundkörpers 2 her belichtet und anschließend wie beschrieben entwickelt.

In einem weiteren Schritt wird nun ein Ätzresist 53 partiell auf die erste Lackschicht 3 und die partielle Lackschicht 23 aufgebracht. Anschließend werden die erste Lackschicht 3 und die partielle Lackschicht 23 dort entfernt, wo sie nicht von dem Ätzresist 53 bedeckt sind.

Der Ätzresist 53 besteht bevorzugt aus Acrylat-, Polyester-, Epoxy-, Polyurethan-Harze oder Acrylatcopolymere mit einer Schichtdicke von 0,1 µm bis 10 µm, bevorzugt von 0,1 µm bis 5 µm.

Der Ätzresist 53 kann dabei auch in Form eines Musters, Rasters oder Motivs, insbesondere auch in Form eines feinen Linienmusters aufgebracht werden, welches im resultierenden Mehrschichtkörper 1 dann im Farbmuster der ersten Lackschicht 3 und der partiellen Lackschicht 23 eingefärbt ist.

Auch die Ausführungsform nach Fig. 8 entspricht dem Ausführungsbeispiel nach Fig. 3. Hier erfolgt ebenfalls eine Strukturierung der ersten Lackschicht 3 unter Verwendung der partiellen Lackschicht 23 als interne Maske. Im Unterschied zu Fig. 3 ist hier lediglich eine weitere, vollflächige Reflexionsschicht 25 im Grundkörper 2 vorgesehen, die die eingangs bei der Beschreibung des Grundkörpers 2 erläuterten Eigenschaften aufweist.

Auch hier kann anschließend, analog zu Fig. 7, eine weitere Strukturierung durch Aufbringen eines Ätzresists 53 und anschließendes Ätzen erfolgen.

Im Ausführungsbeispiel nach Fig. 9 wird die erste Lackschicht 3 analog zu Fig. 2 als Waschlack verwendet. In dieser Ausführungsform wird die erste Lackschicht 3 zunächst auf eine Reflexionsschicht 25 des Grundkörpers 2 aufgetragen, mittels einer externen Maske oder eines Lasers belichtet und im unbelichteten Bereich 32 bei der Entwicklung entfernt.

Anschließend erfolgt ein Ätzschritt, in welchem die Reflexionsschicht 25 im Bereich 32 entfernt wird. Während des Ätzens wird die Reflexionsschicht im Bereich 31 durch die erste Lackschicht 3 geschützt, so dass sie dort verbleibt.

Anschließend wird eine weitere Reflexionsschicht 52 auf den Grundkörper 2 und die erste Lackschicht 3 aufgebracht, beispielsweise durch Aufdampfen, Sputtern, Gasphasenabscheidung oder dergleichen.

Bei einer anschließenden Behandlung mit Natriummetaperiodatlösung wird die erste Lackschicht 3 zusammen mit der weiteren Reflexionsschicht 52 im ersten Bereich 31 entfernt. Dort verbleibt nun die Reflexionsschicht 25 an der Oberfläche des Grundkörpers 2, während im ersten Bereich 31 die weitere Reflexionsschicht 52 die Oberfläche des Grundkörpers bildet. Dies ist insbesondere sinnvoll, wenn für die Reflexionsschichten 25, 52 unterschiedliche Materialien verwendet werden. So können beispielsweise zwei verschiedene Metalle oder Metalllegierungen komplementär zueinander angeordnet werden.

Auch hier kann anschließend ein partielles Überdrucken mit einem Ätzresist und eine weitere Strukturierung der Reflexionsschichten 25, 52 erfolgen.

Die Ausführungsform nach Fig. 10 ist analog zur Ausführungsform nach Fig. 6. Auch hier wird eine partielle Metallschicht 24 und eine partielle Lackschicht 23 als interne Belichtungsmaske für die erste Lackschicht 3 verwendet. Der Unterschied besteht lediglich in der Schichtreihenfolge. Hier weist die partielle Metallschicht 24 zur ersten Lackschicht 3, während die partielle Lackschicht 23 zur Trägerlage 21 weist.

Diese Schichtreihenfolge ermöglicht es, die partielle Metallschicht 24 ebenfalls unter Verwendung der partiellen Lackschicht 23 zu strukturieren. Hierzu wird zunächst die partielle Lackschicht 23 erzeugt und anschließend die Metallschicht 24 vollflächig aufgebracht. Auf die Metallschicht 24 wird ein photosensitiver Ätzresist aufgetragen, der durch den Grundkörper 2 hindurch belichtet wird. Bei der Verwendung eines positiven Resists verbleibt nach der Entwicklung der Resist in Überdeckung mit der partiellen Lackschicht 23, so dass beim anschließenden Ätzen auch die partielle Metallschicht 24 registergenau deckungsgleich zur partiellen Lackschicht 23 verbleibt.

Nach Entfernung des Resists kann dann, wie bereits anhand Fig. 6 beschrieben, die erste Lackschicht 3 registergenau komplementär zu den Schichten 23, 24 erzeugt werden.

Ausgehend von dem so erzeugten Schichtaufbau kann, wie in Fig. 11 gezeigt, eine weitere Farblackschicht 51 aufgebracht werden. Anschließend wird analog zu Fig. 2 die erste Lackschicht 3 durch saure Natriummetaperiodatlösung entfernt. Dabei wird in den Bereichen, in denen die erste Lackschicht 3 vorliegt, auch die weitere Farblackschicht 51 entfernt, so dass diese nun registergenau deckungsgleich zur partiellen Lackschicht 23 und zur partiellen Metallschicht 24 verbleibt.

### Bezugszeichenliste

- 1: Mehrschichtkörper
- 2: Grundkörper
- 21: Trägerlage
- 22: Schichtverbund
- 23: partielle Lackschicht
- 24: partielle Metallschicht
- 25: Reflexionsschicht
- 3: erste Lackschicht
- 31: belichteter Bereich
- 32: unbelichteter Bereich
- 4: UV-Lichtquelle
- 5: weiterer Schichtverbund
- 51: Farblackschicht
- 52: Reflexionsschicht
- 53: Ätzresist

## Patentansprüche

1. Verfahren zum Herstellen eines Sicherheitselements mit den Schritten
a) Aufbringen einer ersten Lackschicht (3) aus einem wasserbasierten Photolack auf eine Oberfläche eines Grundkörpers (2);
b) Belichten der ersten Lackschicht (3) in einem ersten Bereich (31) wobei die erste Lackschicht (3) in einem zweiten Bereich (32) nicht belichtet wird
c) Entfernen der ersten Lackschicht (3) im zweiten Bereich (32);
**dadurch gekennzeichnet,**
**dass** zum Aufbringen der ersten Lackschicht (3) ein wässriger Photolack verwendet wird, welcher zumindest ein wasserlösliches Polymer, zumindest ein filmbildendes Polymer, zumindest ein Additiv und zumindest einen Photoinitiator enthält.

2. Verfahren nach Anspruch 1,
**dadurch gekennzeichnet,**
**dass** der Grundkörper zumindest eine zweite Lackschicht aus einem lösemittelbasierten Lack umfasst.

3. Verfahren nach Anspruch 1 oder 2,
**dadurch gekennzeichnet,**
**dass** die erste Lackschicht auf eine Oberfläche der zweiten Lackschicht aufgebracht wird.

4. Verfahren nach einem der Ansprüche 1 bis 3,
**dadurch gekennzeichnet,**
**dass** zumindest eine weitere Schicht auf die erste Lackschicht aufgebracht wird.

5. Verfahren nach Anspruch 4,
**dadurch gekennzeichnet,**
**dass** nach dem Aufbringen der zumindest einen weiteren Schicht die erste Lackschicht und die zumindest eine weitere Schicht im ersten Bereich entfernt wird.

6. Verfahren nach Anspruch 5,
**dadurch gekennzeichnet,**
**dass** die erste Lackschicht und die zumindest eine weitere Schicht durch Behandlung mit einer sauren Natriummetaperiodatlösung, insbesondere einer wässrigen Lösung von 1,5 Gew.-% Natriummetaperiodat und 0,05 Gew.-% Schwefelsäure, entfernt wird.

7. Verfahren nach Anspruch 6,
**dadurch gekennzeichnet,**
**dass** die Behandlung mit der sauren Natriummetaperiodatlösung bei einer Temperatur von 15°C bis 70°C, bevorzugt von 25°C bis 50°C, und/oder einer Behandlungsdauer von 600s bis 1s,bevorzugt von 120s bis 10s, erfolgt, wobei insbesondere der sauren Natriummetaperiodatlösung ein nichtionisches Tensid zugesetzt wird, insbesondere ausgewählt aus der Gruppe Ethoxylat, Alkoxylate primärer oder sekundärer Fettalkohole, Alkylphenole, Ethylenoxid/Propylenoxid-Copolymerisate, Aminethoxylate, Alkylpolyglycolide, Fettaminoxide, Fettsäurealkanolamide, Fettsäurealkylglucamide.

8. Verfahren nach einem der Ansprüche 4 bis 7,
**dadurch gekennzeichnet,**
**dass** die zumindest eine weitere Schicht eine dritte Lackschicht, insbesondere aus einem lösemittelbasierten Lack, ist oder umfasst und/oder dass die zumindest eine weitere Schicht eine Reflexionsschicht ist oder umfasst.

9. Verfahren nach Anspruch 8,
**dadurch gekennzeichnet,**
**dass** die erste Lackschicht auf eine Reflexionsschicht des Grundkörpers aufgebracht wird und vor dem Aufbringen der zumindest einen weiteren Schicht die Reflexionsschicht des Grundkörpers im ersten Bereich insbesondere durch Ätzen entfernt wird
und/oder dass die erste Lackschicht lediglich auf einen Teilbereich der Oberfläche des Grundkörpers aufgebracht wird.

10. Verfahren nach einem der Ansprüche 1 bis 9,
**dadurch gekennzeichnet,**
**dass** auf einen Teilbereich der ersten Lackschicht und/oder der zumindest einen weiteren Schicht ein Ätzresist aufgebracht wird und die erste Lackschicht und/oder die zumindest eine weitere Schicht dort entfernt wird, wo sie nicht von dem Ätzresist bedeckt ist.

11. Verfahren nach einem der Ansprüche 1 bis 10,
**dadurch gekennzeichnet,**
**dass** die Belichtung von der Seite des Grundkörpers her erfolgt.

12. Verfahren nach Anspruch 11,
**dadurch gekennzeichnet,**
**dass** der Grundkörper zumindest eine partielle Schicht, insbesondere eine vierte Lackschicht und/oder eine Reflexionsschicht, umfasst, die im ersten Bereich für einen zur Belichtung der ersten Lackschicht verwendeten Wellenlängenbereich transparent und im zweiten Bereich für einen zur Belichtung der ersten Lackschicht verwendeten Wellenlängenbereich intransparent ist.

13. Verfahren nach einem der Ansprüche 1 bis 12,
**dadurch gekennzeichnet,**
**dass** zum Entfernen der ersten Lackschicht im zweiten Bereich eine Wasser mit einem Zusatz von Isopropanol, insbesondere mit 1% bis 30% Isopropanol, bevorzugt mit 5% Isopropanol, verwendet wird.

14. Verfahren nach einem der Ansprüche 1 bis 13,
**dadurch gekennzeichnet,**
**dass** die erste und/oder zweite und/oder dritte und/oder vierte Lackschicht Farbmittel, insbesondere bunte oder unbunte Pigmente und/oder Effektpigmente, UV-anregbare Fluoreszenzpigmente, Dünnschichtfilmsysteme, cholesterische Flüssigkristalle, Farbstoffe und/oder metallische oder nichtmetallische Nanopartikel umfasst und/oder dass die erste und/oder zweite und/oder dritte und/oder vierte Lackschicht jeweils unterschiedliche Farbmittel umfassen und/oder dass die erste und/oder zweite und/oder dritte und/oder vierte Lackschicht in Form eines graphischen Motivs, alphanumerischen Zeichens, Logos, Bildes, Musters, insbesondere Guillochenmusters, aufgebracht und/oder strukturiert wird.

## Claims

1. Method for producing a security element having the following steps:
a) applying a first lacquer layer (3) made of a water-based photo lacquer onto a surface of a base body (2);
b) exposing the first lacquer layer (3) in a first region (31), wherein the first lacquer layer (3) is not exposed in a second region (32),
c) removing the first lacquer layer (3) in the second region (32); **characterised in that**
an aqueous photo lacquer is used for applying the first lacquer layer (3), said aqueous photo lacquer containing at least one water-soluble polymer, at least one film-forming polymer, at least one additive and at least one photoinitiator.

2. Method according to claim 1,
**characterised in that**
the base body comprises at least one second lacquer layer made of a solvent-based lacquer.

3. Method according to claim 1 or 2,
**characterised in that**
the first lacquer layer is applied onto a surface of the second lacquer layer.

4. Method according to one of claims 1 to 3,
**characterised in that**
at least one further layer is applied onto the first lacquer layer.

5. Method according to claim 4,
**characterised in that**,
after applying the at least one further layer, the first lacquer layer and the at least one further layer is removed in the first region.

6. Method according to claim 5,
**characterised in that**
the first lacquer layer and the at least one further layer is removed by treatment with an acidic sodium metaperiodate solution, in particular an aqueous solution of 1.5% by weight of sodium metaperiodate and 0.05% by weight of sulphuric acid.

7. Method according to claim 6,
**characterised in that**
the treatment with the acidic sodium metaperiodate solution is carried out at a temperature of from 15°C to 70°C, preferably from 25°C to 50°C and/or a treatment duration of from 600s to 1s, preferably from 120s to 10s, wherein a non-ionic surfactant is added, in particular, to the acidic sodium metaperiodate solution, in particular selected from the group of ethoxylate, alkoxylates of primary or secondary fatty alcohols, alkyl phenols, ethylene oxide/propylene oxide copolymerisates, amino ethoxylates, alkyl polyglycolides, fatty amino oxides, fatty acid alkanolamides, fatty acid alkyl glucamides.

8. Method according to one of claims 4 to 7,
**characterised in that**
the at least one further layer is or comprises a third lacquer layer, in particular made of a solvent-based lacquer, and/or the at least one further layer is or comprises a reflection layer.

9. Method according to claim 8,
**characterised in that**
the first lacquer layer is applied onto a reflection layer of the base body, and the reflection layer of the base body is removed in the first region, in particular by etching, before applying the at least one further layer,
and/or the first lacquer layer is only applied onto a partial region of the surface of the base body.

10. Method according to one of claims 1 to 9,
**characterised in that**
an etch resist is applied onto a partial region of the first lacquer layer and/or the at least one further layer, and the first lacquer layer and/or the at least one further layer is removed from where it is not covered by the etch resist.

11. Method according to one of claims 1 to 10,
**characterised in that**
the exposure is carried out from the side of the base body.

12. Method according to claim 11,
**characterised in that**
the base body comprises at least one partial layer, in particular a fourth lacquer layer and/or a reflection layer, which is transparent in the first region for a wavelength range used for exposing the first lacquer layer and is not transparent in the second region for a wavelength range used for exposing the first lacquer layer.

13. Method according to one of claims 1 to 12,
**characterised in that**
a water with an addition of isopropanol, in particular with 1% to 30% isopropanol, preferably with 5% isopropanol, is used to remove the first lacquer layer in the second region.

14. Method according to one of claims 1 to 13,
**characterised in that**
the first and/or second and/or third and/or fourth lacquer layer comprises colourants, in particular multi-coloured or uncoloured pigments and/or effect pigments, UV-excitable fluorescence pigments, thin layer film systems, cholesteric liquid crystals, dyes and/or metallic or non-metallic nanoparticles,
and/or the first and/or second and/or third and/or fourth lacquer layer each comprise different colourants,
and/or the first and/or second and/or third and/or fourth lacquer layer is applied and/or structured in the form of a graphical motif, alphanumerical symbol, logo, image, pattern, in particular Guilloche pattern.

## Revendications

1. Procédé de fabrication d'un élément de sécurité avec les étapes
a) d'application sur une surface d'un corps de base (2) d'une première couche de vernis (3) composée d'un vernis photosensible à base d'eau ;
b) d'exposition de la première couche de vernis (3) dans une première zone (31), dans lequel la première couche de vernis (3) n'est pas exposée dans une deuxième zone (32),
c) de retrait de la première couche de vernis (3) dans la deuxième zone (32) ;
**caractérisé en ce**
**que** pour appliquer la première couche de vernis (3), un vernis photosensible aqueux est utilisé, lequel contient au moins un polymère hydrosoluble, au moins un polymère filmogène, au moins un additif et au moins un photo-initiateur.

2. Procédé selon la revendication 1,
**caractérisé en ce**
**que** le corps de base comprend au moins une deuxième couche de vernis composée d'un vernis à base de solvant.

3. Procédé selon la revendication 1 ou 2,
**caractérisé en ce**
**que** la première couche de vernis est appliquée sur une surface de la deuxième couche de vernis.

4. Procédé selon l'une quelconque des revendications 1 à 3,
**caractérisé en ce**
**qu'**au moins une autre couche est appliquée sur la première couche de vernis.

5. Procédé selon la revendication 4,
**caractérisé en ce**
**qu'**après l'application de l'au moins une autre couche, la première couche de vernis et l'au moins une autre couche sont retirées dans la première zone.

6. Procédé selon la revendication 5,
**caractérisé en ce**
**que** la première couche de vernis et l'au moins une autre couche sont retirées par traitement avec une solution acide de métapériodate de sodium, en particulier une solution aqueuse de 1,5 % en poids de métapériodate de sodium et 0,05 % en poids d'acide sulfurique.

7. Procédé selon la revendication 6,
**caractérisé en ce**
**que** le traitement est effectué avec la solution acide de métapériodate de sodium à une température de 15 °C à 70 °C, de manière préférée de 25 °C à 50 °C,
et/ou pendant une durée de traitement de 600 s à 1 s, de manière préférée de 120 s à 10 s, dans lequel un agent tensio-actif non ionique est ajouté en particulier à la solution acide de métapériodate de sodium, choisi en particulier parmi le groupe éthoxylate, alcoxylate d'alcools gras primaires ou secondaires, alkylphénols, copolymérisats d'oxyde d'éthylène/d'oxyde de propylène, éthoxylates d'amine, polyglycolides d'alkyle, oxydes gras d'amine, alcanolamides d'acide gras, alkylglucamides d'acide gras.

8. Procédé selon l'une quelconque des revendications 4 à 7,
**caractérisé en ce**
**que** l'au moins une autre couche est ou comprend une troisième couche de vernis, en particulier composée d'un vernis à base de solvant, et/ou que l'au moins une autre couche est ou comprend une couche réfléchissante.

9. Procédé selon la revendication 8,
**caractérisé en ce**
**que** la première couche de vernis est appliquée sur une couche réfléchissante du corps de base et la couche réfléchissante du corps de base est retirée en particulier par gravure dans la première zone avant l'application de l'au moins une autre couche,
et/ou que la première couche de vernis est appliquée seulement sur une zone partielle de la surface du corps de base.

10. Procédé selon l'une quelconque des revendications 1 à 9,
**caractérisé en ce**
**qu'**une réserve de gravure est appliquée sur une zone partielle de la première couche de vernis et/ou de l'au moins une autre couche, et la première couche de vernis et/ou l'au moins une autre couche sont retirées là où elles ne sont pas recouvertes de la réserve de gravure.

11. Procédé selon l'une quelconque des revendications 1 à 10,
**caractérisé en ce**
**que** l'exposition a lieu depuis le côté du corps de base.

12. Procédé selon la revendication 11,
**caractérisé en ce**
**que** le corps de base comprend au moins une couche partielle, en particulier une quatrième couche de vernis et/ou une couche réfléchissante, qui sont transparentes dans la première zone pour une plage de longueurs d'onde utilisée pour l'exposition de la première couche de vernis et sont opaques dans la deuxième zone pour une plage de longueurs d'onde utilisée pour l'exposition de la première couche de vernis.

13. Procédé selon l'une quelconque des revendications 1 à 12,
**caractérisé en ce**
**que** pour retirer la première couche de vernis dans la deuxième zone, une eau avec un ajout d'isopropanol, en particulier avec 1 % à 30 % d'isopropanol, de manière préférée avec 5 % d'isopropanol, est utilisée.

14. Procédé selon l'une quelconque des revendications 1 à 13,
**caractérisé en ce**
**que** la première et/ou la deuxième et/ou la troisième et/ou la quatrième couche de vernis comprennent des agents colorants, en particulier des pigments colorés ou non colorés, et/ou des pigments à effet, des pigments fluorescents pouvant être excités sous l'effet d'UV, des systèmes de film à couche mince, des cristaux liquides cholestériques, des matières colorantes et/ou des nanoparticules métalliques ou non métalliques, et/ou que la première et/ou la deuxième et/ou la troisième et/ou la quatrième couche de vernis comprennent respectivement différents agents colorants, et/ou que la première et/ou la deuxième et/ou la troisième et/ou la quatrième couche de vernis sont appliquées et/ou structurées sous la forme d'un motif graphique, de caractères alphanumériques, de logos, d'images, de motifs, en particulier de motifs de guillochis.
